Europäisches Patentamt

European Patent Office

Office européen des brevets

(11) Publication number: **0 375 467**
**A1**

# EUROPEAN PATENT APPLICATION

(21) Application number: **89313579.8**

(22) Date of filing: **23.12.89**

(51) Int. Cl.5: **H04N 5/44, H03J 9/06**

(30) Priority: **23.12.88 GB 8830196**

(43) Date of publication of application:
**27.06.90 Bulletin 90/26**

(84) Designated Contracting States:
**DE ES FR GB**

(71) Applicant: DUNWILCO ( 153 ) LIMITED
**Murray House 4 Redheughs Rigg
South Gyle Edinburgh EH12 9DQ
Scotland(GB)**

(72) Inventor: **McDonald, Brian
26 Shottsburn Road By Salsburgh
Lanarkshire Scotland(GB)**

(74) Representative: **Pacitti, Pierpaolo A.M.E. et al
Murgitroyd and Company Mitchell House 333
Bath Street
Glasgow G2 4ER Scotland(GB)**

(54) **Control system.**

(57) A control system for satellite broadcast receiving apparatus comprises a television receiver 10 capable of receiving signals from an aerial 11 or from a satellite decoder 12. The television receiver 10 includes a remote control signal receiver 30 which receives a plurality of coded remote control signals from an infrared remote control unit 21 and decodes said signals by micro-processor means in the signal receiver 30 to switch the television receiver 10 to receive signals either from the standard aerial 11 or from the satellite broadcast decoder 12. In addition the remote control unit allows the selection of any one of a desired broadcast channel or any one of a desired normal channel.

*FIG.1*

EP 0 375 467 A1

## Control System

This invention relates to a control system for satellite broadcast receiving apparatus.

In satellite broadcasting for use in domestic environments there are provided means for decoding the signal received by the satellite, this decoded signal being passed to the television receiver. In such installations where a number of channels are received by a single satellite dish, it is necessary to provide means to enable a television receiver to receive signals from the decoder as opposed to normal television signals. Thereafter, additional means are provided for selecting a desired one of a plurality of satellite broadcast channels.

Effectively this means that in normal circumstances the television remote control will only operate the television and a separate remote control will be required to operate the satellite receiver. If a video recorder is also included in the system then it is possible to have three separate remote control devices.

Previously this problem has been overcome by providing a programmable remote control unit which is capable of learning and reproducing the signals from a number of different remote control devices. This however requires the user to learn a new seris of commands for effective overall operation. Alternatively if a receiver, satellite decoder and video recorder are sourced from the samer supplier then they may be matched units which accept signals from a single remote control. In practice however the majority of people source the separate parts of a television system from different suppliers and possibly at different times and so this situation rarely arises.

It is an object of the present invention to provide a control system which obviates the need for two separate selection systems.

According to the present invention there is provided a control system for television broadcast receiving apparatus comprising means for generating first and second signals to switch the receiver selectively to receive signals from a satellite broadcast decoding unit or a terrestial broadcast receiving aerial and for generating a signal to select one of a plurality of broadcast channels.

Preferably, the signal generating means comprises an infrared signal producing device.

Preferably also, said system includes a programmable microprocessor for decoding the infra red signals, switching the receiver between satellite and terrestial receiving modes and selecting a broadcast channel.

Preferably also the microprocessor is capable of recognising signals from the remote control unit not normally allocated to a function for the receiver and allocating to said signal a selected functiion such that the single remote control unit can be utilised to control the function of the receiver and one or more other items of apparatus such as a satellite decoder or video recorder.

Embodiments of the present invention will now be described, by way of example, with reference to the accompanying drawing, in which:-

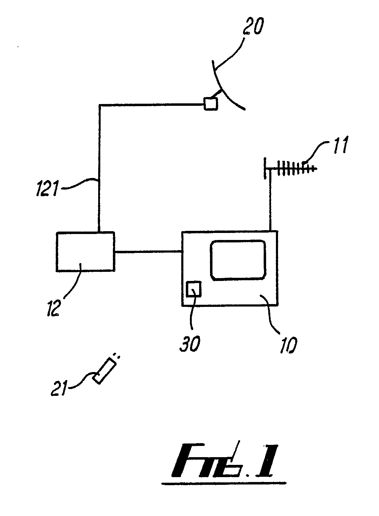

Fig. 1 is a block diagram of a control system made in accordance with the present invention.

Referring to the drawing, a control system for satellite broadcast receiving apparatus comprises a television receiver 10 which is capable of receiving signals from a normal television aerial 11 or from a satellite broadcast decoder 12. The decoder 12 receives signals from a satellite dish 20 via a coaxial cable 121. The television receiver 10 includes a remote control signal receiver 30 which receives a plurality of coded remote control signals from an infrared remote control unit 21. Each of these remote control coded signals is decoded by microprocessor means in the signal receiver 30 to switch the television receiver 10 to receive signals either from the standard aerial 11 or from the satellite broadcast decoder 12.

The micro-procesor means 30 can be programmed to interpret the signals from the remote control 21 such as to select any one of a desired broadcast channel or any one of a desired normal channel.

Further details of the operation and programming of one particular example of a system in accordance with the present invention will now be described.

Essentially the system provides the receiver with the facility to recognize remote control handsets other than it's own. The functions available from the auxillary remote control are channel selection - either increment/decrement channel or favourite channels-and TeleText/TV selection.

Channel Selection - any key on the handset can be programmed with any of the receiver's 99 channels. When this key is pressed, the receiver will select this channel. The Increment and Decrement keys will select the next and previous channels, skipping any that are locked out.

TeleText/TV - When the Teletext key is pressed, the receiver will ignore all other keys until the TV key has been pressed. This is to facilitate TeleText page selection without affecting the receiver.

A table is constucted in the EEPROM which holds the commands associated with each of the available functions. Incoming commands are compared to this table and the appropriate function is executed if a match is found.

Before the above can be achieved the microprocessor must first be put through a learning process.

In order to recognize commands from the auxilliary handset, the receiver must learn the characteristics of that handset ie. how it issues commands when a key is pressed. There are two fundamental parameters needed; the data bit time and the data transmission method. The data bit time can vary from 500 uS up to 5 mS. The transmission methods most commonly used are 'Pulse Position Modulated (PPM)' and 'Pulse Width Modulated (RC5)'. Once these parameters are known, commands can be received from the handset. To find these parameters, the data from the handset must be sampled and processed. Each zero to one transition in the data stream is seen as an event and 16 of these events are collected. The next stage is to perform a correlation procedure on the data sample to extract the fundamental frequency. This then becomes the handset's Bit Time (t). From this, the data sample is further processed to determine the encoding method employed on the data. This means whether it is a PPM or an RC5 type encoding. If the data sample consists of 1t,2t,3t or 2t,3t,6t time periods between events, then the handset is a PPM type with 1t,2t,3t or 2t3t6t characteristics. If any occurences of 4t are detected, then the handset belongs to the RC5 class.

Once the microprocessor has interrogated the handset in this way and identified the handset characteristics commands can be assembled by the CommandAssembly procedure. This procedure analyses the incoming data stream looking for events which are a multiple of the basic bit time (t) ie. 1t,2t,3t,. These events are assembled into a command until a Gap is seen. A Gap is a period where no events have occured for greater than 6 time. This is essential to be able to synchronize to the data stream. When two commands have been received which exactly match each other, then the command is accepted and passed to the mainstream processes.

Thus the microprocessor is able to allocate particular commands to signals from the handset and thus the handset operates in the normal way for its standard function with previously unused signals being allocated to new commands.

Accordingly, it is now possible, using the system of the invention, to control a television receiver capable of receiving broadcast channels such that a desired one of a normal broadcast channel or a desired one of a satellite broadcast channel may be selected using a single remote control unit.

Modifications and improvements may be incorporated without departing from the scope of the invention.

## Claims

1. A control system for television broadcast receiving apparatus comprising means for generating first and second signals to switch the receiver selectively to receive signals from either a satellite broadcast decoding unit or a terrestial broadcast receiving aerial and for generating a signal to select one of a series of broadcast channels.

2. A control system as claimed in Claim 1, wherein the signal generating means comprises an infra red signal producing device.

3. A control system as claimed in Claim 1 or 2, wherein the control system includes a programmable microprocessor for decoding the infra red signals switching the receiver between satellite and terrestial receiving modes and selecting a broadcast channel.

4. A control system as claimed in Claim 3, wherein the mircoprocessor is capable of recognising signals from the remote control unit not normally allocated to a function for the receiver and allocating to said signal a selected function such that the single remote control unit can be utilised to control the function of the receiver and one or more other items of apparatus such as a satellite decoder or video recorder.

_Fig.1_

| | **DOCUMENTS CONSIDERED TO BE RELEVANT** | | EP 89313579.8 |
|---|---|---|---|

| Category | Citation of document with indication, where appropriate, of relevant passages | Relevant to claim | CLASSIFICATION OF THE APPLICATION (Int. Cl.X) 5 |
|---|---|---|---|
| X | EP - A2 - 0 285 869 (BRIONVEGA) * Abstract; fig.; column 3, lines 16-20 * | 1,3,4 | H 04 N 5/44 H 03 J 9/06 |
| A | US - A - 4 743 968 (MOGI) * Fig. 1 * | 1,2 | |
| A | EP - A1 - 0 033 434 (BRIONVEGA) * Abstract; fig. 1; page 4, lines 20-24 * | 1,4 | |

TECHNICAL FIELDS
SEARCHED (Int. Cl.X) 5

H 04 N 5/00
H 03 J 9/00

The present search report has been drawn up for all claims

| Place of search | Date of completion of the search | Examiner |
|---|---|---|
| VIENNA | 19-02-1990 | BENISCHKA |